# FASCICULE DE BREVET EUROPEEN

(11) **EP 3 035 473 B1**
(45) Date de publication et mention de la délivrance du brevet: **19.07.2017**
(21) Numéro de dépôt: 15200467.7
(22) Date de dépôt: 16.12.2015
(51) Int. Cl.: H02H 7/08, H02H 7/06, H02H 3/08, B60L 3/00, B60L 3/04, B60L 11/18, B60L 15/00, B61C 3/00, B60L 3/06, B60L 15/38

(54) **SYSTÈME DE TRACTION ÉLECTRIQUE POUR UN VÉHICULE FERROVIAIRE ; PROCÉDÉ DE MISE EN SÉCURITÉ MIS EN OEUVRE PAR CE SYSTÈME**
ELEKTRISCHES ZUGSYSTEM FÜR EIN SCHIENENFAHRZEUG, SICHERUNGSVERFAHREN, DAS DURCH DIESES SYSTEM AUSGEFÜHRT WIRD
ELECTRIC TRACTION SYSTEM FOR A RAILWAY VEHICLE ; PROTECTION METHOD REALISED BY SUCH A SYSTEM

(30) Priorité: 16.12.2014 FR 1462508
(43) Date de publication de la demande: 22.06.2016
(73) Titulaire: ALSTOM Transport Technologies, 93400 Saint-Ouen (FR)
(72) Inventeur: CYPERS, David, 65310 Odos (FR); DESPORTES, Guillaume, 65700 Maubourguet (FR)
(74) Mandataire: Lavoix

(56) Documents cités:
- EP-A1- 1 544 974
- EP-A1- 2 515 419
- EP-A1- 2 634 884
- WO-A1-2008/122602
- FR-A1- 2 978 628

## Description

La présente invention concerne un système de traction électrique pour un véhicule ferroviaire, comportant une machine électrique synchrone et un circuit d'alimentation, le circuit d'alimentation comportant un convertisseur, connecté à une source de tension continue et propre à délivrer une tension polyphasée adaptée à l'alimentation de la machine, à laquelle le convertisseur est connecté par une pluralité de câbles électriques, un dispositif d'isolement et des moyens de mise en court-circuit des phases de la machine, placés en aval du dispositif d'isolement, le système comportant en outre des moyens de pilotage du convertisseur, des moyens de détection primaires d'une surintensité dans des branches de sortie du convertisseur, et des moyens de mise en sécurité propre à actionner en ouverture le dispositif d'isolement lors de la réception d'un signal de détection primaire émis par les moyens de détection primaires.

Le document EP 2 634 884 divulgue un tel système comportant, en tant que moyens de détection primaires, des capteurs de courants pour la détection d'une surintensité en sortie du convertisseur.

Dans le document EP 2 634 884, le procédé de surveillance mis en oeuvre prévoit le suivi des mesures délivrées par les capteurs de courant afin de détecter la survenue d'un défaut du type court-circuit, puis, dans ce cas, l'actionnement des disjoncteurs d'isolement afin d'isoler le convertisseur de la machine électrique, qui, mise en rotation par les roues du véhicule ferroviaire en mouvement, fonctionne alors en générateur de courant.

Le procédé de mise en sécurité prévoit ensuite d'identifier si le court-circuit est du type interne à la machine électrique ou externe à celle-ci. Si le court-circuit est interne, le procédé prévoit l'actionnement des moyens de mise en court-circuit des phases de la machine électrique (opération dite de symétrisation), par fermeture des moyens de mise en court-circuit.

Cependant, ce document de l'état de la technique ne décrit pas la manière de détecter si un défaut ayant occasionné l'actionnement du disjoncteur d'isolement est un défaut interne à la machine électrique.

Si le court-circuit à l'origine des surintensités dans les branches du convertisseur est situé en aval du disjoncteur d'isolement, c'est-à-dire s'il s'agit soit d'un court-circuit externe à la machine électrique, par exemple entre les câbles électriques reliant chaque branche du convertisseur à chaque phase de la machine électrique, soit un court-circuit interne à la machine électrique, le fait d'ouvrir le disjoncteur ne suffit pas pour isoler le court-circuit de la source d'alimentation, en l'occurrence le moteur de traction tant que celui-ci est en rotation.

Il est à noter qu'un court-circuit aval entre une phase de la machine électrique et la masse est isolable par l'ouverture du disjoncteur d'isolement. Toutefois, un tel défaut électrique peut évoluer en court-circuit entre-phases, qui lui n'est pas isolable par l'ouverture du disjoncteur d'isolement. Un tel défaut est ici considéré comme un court-circuit aval non isolable.

Un court-circuit peut-être « franc », lorsque les deux conducteurs sont en contact direct l'un avec l'autre, ou « non franc », lorsque les deux conducteurs ne se touchent pas directement, mais sont reliés par l'intermédiaire d'un milieu présentant une certaine impédance. Dans ce dernier cas, le court-circuit se traduit par la formation d'un arc électrique permanent ou intermittent. Ce type de défaut développe une énergie conduisant à la combustion des composants et des matériaux environnants l'arc électrique : vaporisation du matériau, modification des propriétés du matériau, etc.

Notons qu'un défaut franc peut évoluer en un défaut non franc par surchauffe et dégradation des matériaux des conducteurs initialement en contact.

Un court-circuit non franc interne à la machine électrique peut conduire à la destruction de la machine électrique avec des risques d'incendie (apparition de flammes : l'arc électrique est présent jusqu'à la consumation du cercle de phase) et / ou de blocage du rotor (la matière du cercle de phase vient se loger dans l'entrefer, dégradant ainsi la frette et libérant les aimants montés en surface).

L'invention a donc pour but de pallier ce problème, en permettant notamment de pouvoir discriminer entre un défaut aval interne à la machine électrique et un défaut aval externe à la machine électrique, de manière à sélectionner l'action adéquate à réaliser : simple ouverture du disjoncteur d'isolement ou nécessité d'effectuer, en plus, une symétrisation entre phases.

L'invention a donc pour objet un système de traction du type précité caractérisé en ce qu'il comporte en outre des moyens de détection secondaires propres à détecter la présence d'un défaut du type court-circuit en aval du dispositif d'isolement et à émettre un signal de détection secondaire vers les moyens de mise en sécurité, et en ce que les moyens de mise en sécurité sont propres à actionner en fermeture les moyens de mise en court-circuit des phases de la machine lors de la réception du signal de détection secondaire, à condition qu'ils aient déjà reçu un signal de détection primaire émis par les moyens de détection primaires et ayant conduit à l'actionnement en ouverture du dispositif d'isolement.

Suivant des modes particuliers de réalisation, le système comporte une ou plusieurs des caractéristiques suivantes, prises isolément ou suivant toutes les combinaisons techniquement possibles :
- les moyens de détection secondaires comportent au moins un capteur de température, propre à mesurer une température correspondant à une température interne de la machine électrique synchrone.
- les moyens de détection secondaires comportent un dispositif de détection secondaire propre à calculer une variation temporelle de la température mesurée par le ou chaque capteur de température.
- le dispositif de détection secondaire compare la variation temporelle de la température à un seuil prédéterminé, et émet un signal de détection d'un court-circuit lorsque la variation temporelle de la température est supérieure audit seuil prédéterminé.
- le seuil prédéterminé est supérieur à +1,0°C/s, notamment égal à +1,7°C/s.
- les moyens de détection secondaires sont également propres à discriminer si le défaut détecté par les moyens de détection primaires est un court-circuit non franc externe à la machine électrique synchrone du type amorçage entre les câbles électrique, en comparant la variation temporelle de la température à un second seuil prédéterminé, valant environ +0,5°C/min.
- les moyens de détection secondaires comportent au moins deux capteurs de tensions permettant de mesurer un déséquilibre en tension entre les phases de la machine électrique synchrone, les capteurs de tension étant placés au plus près des bornes d'alimentation de la machine électrique synchrone.
- les moyens de détection secondaires comportent un dispositif de détection propre à calculer un écart en tension à partir des mesures délivrées par les capteurs de tension et à générer un signal de détection d'un court-circuit non franc interne à la machine électrique synchrone lorsque l'écart calculé est supérieur à un seuil prédéterminé.
- un capteur de tension est connecté entre les bornes d'alimentation de deux phases différentes ; ou est connecté entre une borne d'alimentation d'une phase et un point commun de connexion des différents capteurs de tension entre eux, ce point commun pouvant être connecté à une masse électrique du système.

La détection d'un court-circuit non franc interne à la machine peut se faire par mesure des tensions entre les phases de la machine ou par mesure de la température interne à la machine.

Une fois un court-circuit non franc interne détecté, une action de symétrisation de la machine est entreprise, qui consiste à court-circuiter entre elles les différentes phases de celle-ci de manière à éteindre l'arc de court-circuit qui se développe à l'intérieur de la machine, à rééquilibrer le court-circuit entre phases et ainsi éviter des pulsations de couple qui résultent de ce déséquilibre.

L'invention a également pour objet un procédé de mise en sécurité mis en oeuvre dans le système de traction précédent, caractérisé en ce qu'il comporte les étapes consistant successivement à : détecter une surintensité dans au moins une branche de sortie du convertisseur ; actionner en ouverture le dispositif d'isolement; puis détecter un défaut du type court-circuit en aval du dispositif d'isolement ; et, dans l'affirmative ; actionner en fermeture les moyens de mise en court-circuit des phases de la machine électrique synchrone.

L'invention et ses avantages seront mieux compris à la lecture de la description détaillée qui va suivre d'un mode de réalisation particulier, donné uniquement à titre d'exemple non limitatif, cette description étant faite en se référant aux dessins annexés sur lesquels :
- la figure 1 est une représentation schématique d'un système selon un premier mode de réalisation de l'invention ;
- la figure 2 est une représentation schématique d'un système selon un second mode de réalisation de l'invention ;
- la figure 3 est une représentation schématique d'une variante du système selon un second mode de réalisation de l'invention ; et,
- la figure 4 est une représentation schématique d'encore une autre variante du système selon un second mode de réalisation de l'invention.

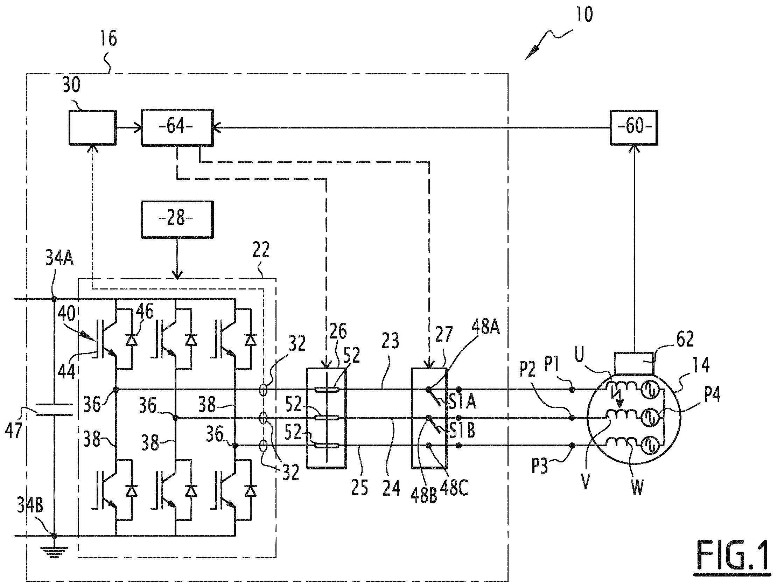

La figure 1 représente schématiquement un premier mode de réalisation d'un système de traction électrique selon l'invention, installé à bord d'un véhicule ferroviaire, tel qu'un métro, un tramway, un train régional, ou un train grande vitesse.

Le système 10 est relié, entre ses bornes d'entrée 34A et 34B, à une source de tension continue (non représentée). La source de tension continue est par exemple une caténaire, reliée à un réseau électrique. La source de tension continue délivre une tension supérieure à 600 V, par exemple égale à 3 kV.

Le système 10 comprend au moins une machine électrique synchrone 14. La machine 14 comporte un rotor et un stator. Le rotor comprend des aimants permanents. Le stator comprend N enroulements, ou phases, destinés à être alimentés par une tension polyphasée adaptée.

La machine 14 est, comme représenté sur les figures, un moteur électrique synchrone, triphasé, à aimants permanents. La machine 14 présente par exemple une puissance nominale comprise entre 50 kW et 2 MW. Chaque phase U, V, W de la machine 14 est connectée entre une borne d'alimentation, respectivement P1, P2, P3, et une borne P4, commune aux différentes phases.

Le système 10 comporte un circuit d'alimentation 16 de la machine 14.

Le circuit d'alimentation 16 comprend un convertisseur 22 de transformation d'une tension continue, délivrée en entrée par la source de tension continue, en une tension alternative triphasée de sortie, adaptée à l'alimentation de la machine 14.

Le convertisseur 22 comporte une borne positive d'entrée 34A, une borne négative d'entrée 34B, qui sont connectées à la source de tension continue.

Le convertisseur 22 comporte trois bornes de sortie 36. Chaque borne de sortie 36 est associée à une phase du courant alternatif polyphasé et est connectée à l'une des phases U, V, W de la machine 14, par l'intermédiaire de câbles électriques 23, 24, 25.

Le convertisseur 22 comprend, pour chaque borne de sortie 36, une branche de commutation 38.

Chaque branche de commutation 38 est connectée entre la borne positive d'entrée 34A et la borne négative d'entrée 34B et comprend deux interrupteurs électriques 40, qui sont connectés en série et dans le même sens, et reliés entre eux par un point milieu. Chaque point milieu constitue l'une des bornes de sortie 36 du convertisseur 22.

Chaque interrupteur électrique 40 est un interrupteur bidirectionnel en courant et unidirectionnel en tension. Chaque interrupteur électrique 40 comprend un transistor 44 et une diode 46 connectée en antiparallèle assurant ainsi des trajets de circulation bidirectionnelle de courant lorsque le transistor 44 est passant.

Un transistor 44 est, par exemple, un transistor bipolaire à grille isolée, également appelé transistor IGBT (de l'anglais « Insulated Gate Bipolar Transistor »). La grille de chaque transistor 44 est reliée à des moyens 28 de pilotage pour recevoir un signal de pilotage adapté.

Le circuit d'alimentation 16 comprend également une banque de stockage disposée entre la source de tension continue et l'entrée du convertisseur 22. La banque de stockage comprend par exemple un condensateur de stockage 47 connecté entre les deux bornes d'entrée 34A, 34B du convertisseur 22.

Le circuit d'alimentation 16 comporte un dispositif d'isolement 26 disposé immédiatement en sortie du convertisseur 22.

Le dispositif d'isolement 26 est propre à isoler la partie aval du système 10 comportant les câbles 23, 24, et 25 et la machine 14, de la partie amont du système 10 constitué du convertisseur 22 et de la banque de stockage 47.

Dans l'exemple de réalisation, le dispositif d'isolement 26 est un dispositif d'isolement à ampoule sous vide, réalisé conformément à l'enseignement de la demande de brevet déposée sous le numéro FR 2 906 194 le 21 septembre 2006 par la société Alstom Transport S.A.

Le dispositif d'isolement 26 comprend trois branches de commutation. Chaque branche de commutation comporte un interrupteur électrique 52 de sectionnement de la phase correspondante de la machine 14. Chaque interrupteur 52 présente deux états : un état ouvert et un état fermé. Il est commandé par les moyens 64 de mise en sécurité. Les différents interrupteurs 52 sont commandés de manière synchrone par un même signal de commande.

En variante, chaque branche de commutation comporte un nombre P d'interrupteurs électriques 52 de sectionnement connectés en série, P étant un nombre entier supérieur ou égal à deux.

Le circuit d'alimentation 16 comprend en outre des moyens 27 de mise en court-circuit des phases de la machine 14, disposés entre le dispositif d'isolement 26 et les bornes P1, P2, P3 de la machine 14. Les moyens 27 sont propres à relier entre elles les trois phases de la machine 14. Avantageusement, les moyens 27 sont placés au plus près de la machine 14, c'est-à-dire connectés directement aux bornes d'alimentation des phases de celle-ci.

Les moyens 27 sont commandés par les moyens 64 de mise en sécurité.

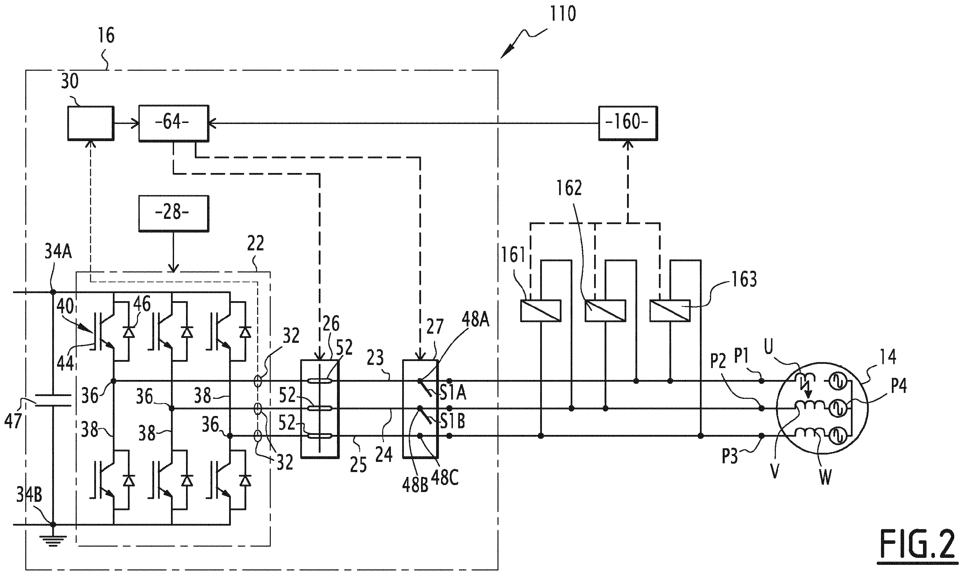

Les moyens 27 sont, dans le présent mode de réalisation, constitués par un contacteur à deux états à coupure classique dans l'air. En variante, les moyens 27 sont constitués par un contacteur à deux états à coupure par ampoule sous vide, comme décrit en regard de la figure 2 du document FR 2 906 194.

Un tel contacteur comporte trois bornes de commutation 48 : une première borne de commutation 48A, une deuxième borne de commutation 48B, et une troisième borne de commutation 48C. Chaque borne d'alimentation P1, P2, P3 de la machine 14 est connectée à l'une des bornes de commutation 48A, 48B, 48C du contacteur 27.

Un interrupteur S1A est disposé entre les bornes 48A, 48B, et un interrupteur S1 B est disposé entre les bornes 48B, 48C.

Chaque interrupteur S1A, S1B présente deux états : un état ouvert et un état fermé. Les deux interrupteurs sont à chaque instant dans le même état, ouvert ou fermé.

Dans son état fermé, l'interrupteur S1A relie la première borne de commutation 48A à la deuxième borne de commutation 48B, de manière à court-circuiter les phases U et V de la machine 14. Dans son état ouvert, l'interrupteur S1A isole l'une de l'autre les phases U et V de la machine 14. Dans son état fermé, l'interrupteur S1 B relie la deuxième borne de commutation 48B à la troisième borne de commutation 48C, de manière à court-circuiter les phases U et W de la machine 14. Dans son état ouvert, l'interrupteur S1 B isole l'un de l'autre les phases V et W de la machine 14.

Chaque interrupteur S1A, S1 B est relié aux moyens 64 de mise en sécurité pour recevoir un même signal de commande.

En variante, le contacteur est remplacé par tout dispositif de commutation présentant deux positions : une première position propre à isoler les unes des autres les phases de la machine 14, et une deuxième position propre à connecter directement entre elles les phases de la machine 14 (dans le présent mode de réalisation, du côté des bornes d'entrée de celle-ci, puisque les phases sont par ailleurs connectées entre elles à un point neutre commun P4).

Le circuit d'alimentation 16 comprend en outre des moyens de pilotage 28. Ils sont propres à envoyer des signaux de commande au convertisseur 22. Les moyens de pilotage 28 comportent un calculateur mettant en oeuvre une loi de commande des interrupteurs 40 du convertisseur 22.

Le système 10 comporte des moyens de surveillance comportant des moyens de détection primaires, des moyens de détection secondaires et des moyens de mise en sécurité.

Les moyens de détection primaires comportent une pluralité de capteurs de courant 32. Chaque capteur 32 est propre à mesurer le courant circulant à travers chaque borne de sortie 36 du convertisseur 22.

Les valeurs instantanées mesurées par chaque capteur 32 sont transmises à un dispositif de détection primaire 30 propre à émettre un signal de détection primaire lorsqu'une surintensité est détectée.

Ce signal de détection primaire est appliqué en entrée des moyens 64 de mise en sécurité.

Lors de la réception du signal de détection primaire, les moyens 64 génèrent un signal de commande en ouverture du dispositif d'isolement 26.

Les moyens de détection secondaires comportent, dans le premier mode de réalisation, un capteur de température 62. Le capteur 62 est propre à mesurer une température instantanée de la machine 14. Le capteur de température est par exemple logé à l'intérieur du carter de la machine 14 pour mesurer la température de l'air de l'entrefer entre le rotor et le stator de celle-ci. De préférence, le capteur est disposé sur l'un des flasques de la machine 14, en regard des têtes de bobine des enroulements du stator de la machine 14, car c'est à ce niveau que l'élévation de la température de l'air est la plus importante. De préférence encore, pour une meilleure sensibilité, le capteur 62 est installé sur le flasque côté commande, par opposition au côté ventilateur de la machine 14.

Les valeurs instantanées mesurées par le capteur 62 sont transmises à un dispositif de détection secondaire 60 propre à calculer le gradient de température, c'est-à-dire la variation temporelle de la température mesurée par le capteur 62.

Si ce gradient est supérieur à un seuil prédéterminé, un signal de détection secondaire est généré par le dispositif de détection secondaire 60. En effet, il a été constaté que, dans la minute qui suit l'apparition d'un court-circuit interne non franc, le gradient de température de l'air de la machine 14 passe à plusieurs degrés par seconde, alors qu'il n'est que de quelques dixièmes de degrés en régime nominal. Par exemple un seuil à 1,7°C/s permet de discriminer la survenue d'un court-circuit interne non franc.

Le signal de détection secondaire généré est appliqué en entrée des moyens 64 de mise en sécurité.

Lors de la réception du signal de détection secondaire, les moyens 64 génèrent un signal de commande en fermeture des interrupteurs des moyens 27.

Le fonctionnement du système 10 va maintenant être expliqué.

Dans la configuration initiale, les interrupteurs 52 du disjoncteur d'isolement sont fermés, et les interrupteurs S1 A, S1 B des moyens 27 sont ouverts. Le convertisseur 22 et la machine 14 sont reliés électriquement via le dispositif d'isolement 26 et le contacteur 27. Un courant alternatif est délivré par le convertisseur 22 au stator 20 de la machine 14.

Lorsqu'un défaut électrique, interne ou externe à la machine 14, survient, les moyens de détection primaires détectent une surintensité dans les courants circulant dans les branches de commutation 38, en sortie du convertisseur 22.

Les moyens 64 de mise en sécurité actionnent en ouverture des interrupteurs 52. Les interrupteurs 52 s'ouvrent, mais les interrupteurs S1A, S1B restant ouverts. La machine 14 est alors isolée de la chaîne d'alimentation 16.

Si le court-circuit est interne à la machine 14, la température mesurée par le capteur 62 augmente de sorte que son gradient dépasse le seuil prédéfini.

La détection de ce défaut conduit le dispositif de détection secondaire 60 à émettre un signal de détection secondaire vers le moyen 64 de sécurité.

Les moyens 64 de mise en sécurité actionnent alors en fermeture des interrupteurs S1A, S1B des moyens 27. Les interrupteurs S1A, S1B se ferment, tout en maintenant les interrupteurs 52 ouverts.

Les trois phases U, V, W de la machine 14 sont alors court-circuitées. Rapidement, l'arc électrique qui s'est formé perd en intensité et disparaît.

Les interrupteurs S1A et S1 B sont maintenus fermés jusqu'à la mise à l'arrêt du véhicule ferroviaire et/ou l'intervention d'un opérateur chargé d'assurer la remise en état du système de traction électrique 10.

Ainsi, l'action de symétrisation est mise en oeuvre uniquement lorsque le court-circuit non franc est du type court-circuit interne, c'est-à-dire si le courant mesuré dans chaque branche du convertisseur est supérieur à une valeur prédéterminée et si le gradient de température est supérieur à un seuil prédéterminé.

De manière à ne pas générer de fausse détection, le capteur de température 62 est testé en permanence. La détection d'un gradient de température supérieur au seuil prédéterminé est considérée comme une fausse détection, dès lors qu'elle n'est pas accompagnée au préalable de la détection d'une surintensité.

En variante, le moyen de détection secondaire est capable également de discriminer un court-circuit non franc externe du type amorçage d'un arc électrique entre les câbles électrique 23, 24 et/ou 25. En effet, il a été constaté qu'il est possible de détecter un tel défaut qui se caractérise par une augmentation de 5°C environ de la température mesurée par le capteur 62 sur une période entre 5 et 15 mn, notamment 10 mn.

Ce type de détection secondaire est relativement lent. En effet, le défaut n'est détecté que lorsque l'arc électrique est déjà au coeur de la machine électrique et a vraisemblablement commencé à faire des dégâts irrémédiables.

Un seconde mode de réalisation va maintenant être présenté en référence à la figure 2, qui permet une mise en sécurité de la machine 14 bien plus rapidement que dans le premier mode de réalisation.

Un élément de la figure 2 qui est identique à un élément de la figure 1 est référencé par le chiffre de référence utilisé pour référencer cet élément identique dans la figure 1.

Le système 110 de la figure 2 est en tout point identique au système 10 de la figure 1 à l'exception des moyens de détection secondaires.

Dans ce second mode de réalisation, les moyens de détection secondaire sont constitués par des capteurs de tension.

Pour détecter avec certitude que le court-circuit est un court-circuit en aval du contacteur d'isolement, les capteurs de tension sont situés au plus près des bornes d'alimentation de la machine 14.

Dans la variante de réalisation de la figure 2, un premier capteur 161 est connecté entre les bornes P1 et P2 de la machine 14, un second capteur 162 est connecté entre les bornes P2 et P3 de la machine 14, et un troisième capteur 163 est connecté entre les bornes P3 et P1 de la machine 14.

Le dispositif de détection secondaire 160 réalise l'acquisition en temps réel de la valeur des tensions mesurées par chacun des capteurs de tension 161, 162 et 163 et détermine des écarts correspondant à des déséquilibres en tension entre paires de phases U, V et W de la machine 14.

Lorsque deux de ces écarts sont supérieurs à un seuil prédéterminé, le dispositif de détection secondaire 160, considère qu'un défaut du type court-circuit est détecté et transmet un signal de détection secondaire aux moyens 64 de mise en sécurité.

Il est à noter que deux capteurs de tension et le calcul de deux écarts sont suffisants à la détection d'un défaut du type court-circuit, dès que l'un des écarts est supérieur à au seuil prédéterminé. Cependant, la présence d'un troisième capteur permet de calculer un troisième écart et ainsi d'obtenir une détection plus sûre, en particulier en cas de défaillance de l'un des capteurs.

Si le disjoncteur d'isolement a été actionné en ouverture, un déséquilibre entre les tensions entre les phases de la machine est le signe d'un court-circuit non franc.

Dans ces conditions, les moyens 64 de mise en sécurité actionnent en fermeture les interrupteurs S1A et S1 B des moyens 27.

Dans cet exemple, la mesure des tensions permet de détecter le court-circuit non-franc rapidement après que le disjoncteur d'isolement a été ouvert (quelques secondes). Les phases de la machine électrique sont alors court-circuitées par l'actionnement des interrupteurs des moyens 27, de manière à éviter ou tout au moins réduire fortement les dégâts occasionnés sur la machine 14.

Pour être totalement effective, la détection doit se faire à partir d'un déséquilibre entre deux tensions, mais aussi à partir des écarts entre l'amplitude de la valeur efficace de chaque tension et une valeur efficace théorique, qui correspond à l'amplitude d'une contre-tension à vide de la machine électrique fonctionnant par exemple à 1000 tours minutes. Cette valeur théorique est valable sur toute la plage de vitesse. On compare donc la valeur efficace mesurée à la valeur efficace théorique.

Pour éviter la fausse détection, les capteurs de tension sont testés en permanence lorsque la machine est alimentée par le convertisseur 22 (régime nominale de fonctionnement du système). Si un déséquilibre et/ou un écart d'amplitude est mesuré alors qu'aucun sur-courant n'a été détecté par les moyens de détection primaires, on considère qu'un des capteurs de tension 161, 162, 163 est défaillant. L'utilisation de trois capteurs permet une redondance assurant l'identification du capteur de tension défaillant.

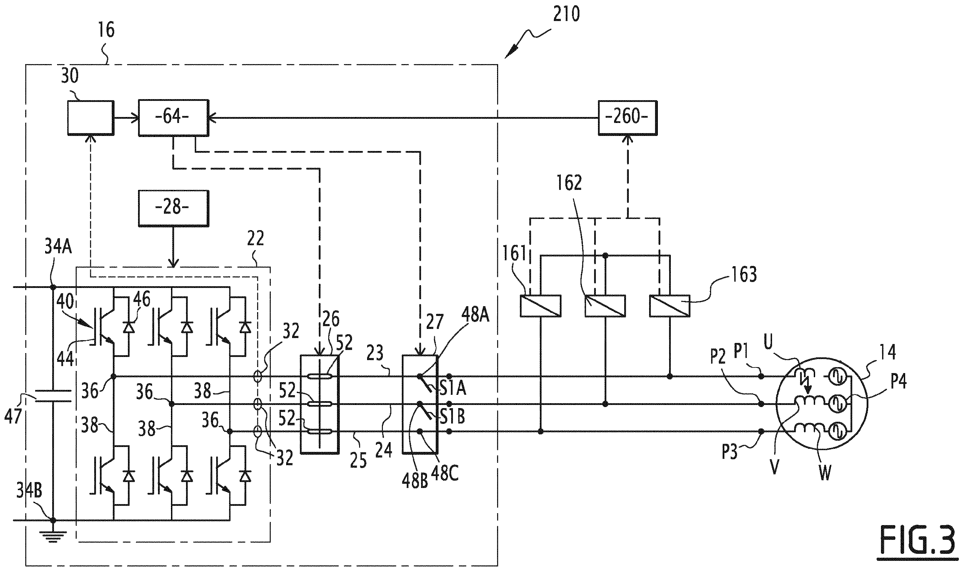

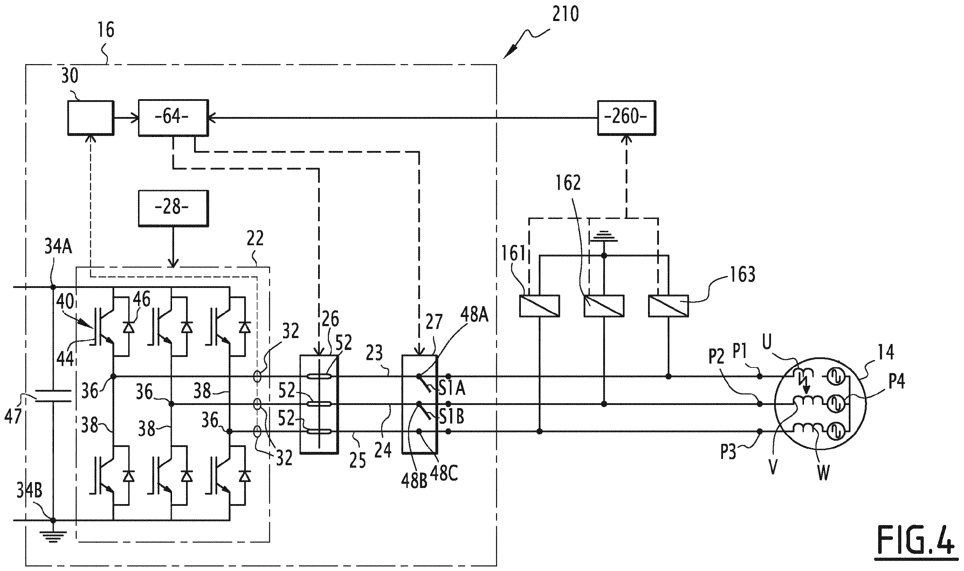

Les figures 3 et 4 représentent des variantes de réalisation du second mode de réalisation.

Dans le système 210 de la figure 3, les capteurs de tensions 161, 162 et 163 sont connectés d'une part à une borne d'entrée de la machine électrique synchrone 14 et d'autre part à un point de connexion commun aux différents capteurs de tension.

Dans le système 210 de la figure 4, ce point commun de connexion entre les capteurs de tensions 161, 162 et 163 est relié à une masse du système.

Le circuit d'alimentation selon l'invention permet de réduire l'amplitude des couples pulsatoires et des courants de court-circuit engendrés au sein de la machine électrique, lors de l'apparition d'un court-circuit interne à la machine électrique, et d'éviter ainsi l'apparition d'un phénomène indésirable.

## Revendications

1. Système de traction électrique (10 ; 110 ; 210) pour un véhicule ferroviaire, comportant une machine électrique synchrone (14) et un circuit d'alimentation (16), le circuit d'alimentation comportant un convertisseur (22), connecté à une source de tension continue et propre à délivrer une tension polyphasée adaptée à l'alimentation de la machine, à laquelle le convertisseur est connecté par une pluralité de câbles électriques (23, 24, 25), un dispositif d'isolement (26) et des moyens (27) de mise en court-circuit des phases de la machine, placés en aval du dispositif d'isolement (26),
le système comportant en outre des moyens (28) de pilotage du convertisseur, des moyens (32, 30) de détection primaires d'une surintensité dans des branches de sortie du convertisseur, et des moyens (64) de mise en sécurité propre à actionner en ouverture le dispositif d'isolement (26) lors de la réception d'un signal de détection primaire émis par les moyens de détection primaires,
**caractérisé en ce qu'**il comporte en outre des moyens (62, 60 ; 161, 162, 163, 160 ; 161, 162, 163, 260) de détection secondaires propres à détecter la présence d'un défaut du type court-circuit en aval du dispositif d'isolement et à émettre un signal de détection secondaire vers les moyens (64) de mise en sécurité,
et **en ce que** les moyens (64) de mise en sécurité sont propres à actionner en fermeture les moyens (27) de mise en court-circuit des phases de la machine lors de la réception du signal de détection secondaire, à condition qu'ils aient déjà reçu un signal de détection primaire émis par les moyens de détection primaires et ayant conduit à l'actionnement en ouverture du dispositif d'isolement.

2. Système (10) selon la revendication 1, dans lequel les moyens de détection secondaires comportent au moins un capteur de température (62), propre à mesurer une température correspondant à une température interne de la machine électrique synchrone (14).

3. Système (10) selon la revendication 2, dans lequel les moyens de détection secondaires comportent un dispositif de détection secondaire (60) propre à calculer une variation temporelle de la température mesurée par le ou chaque capteur de température (62).

4. Système (10) selon la revendication 3, dans lequel le dispositif de détection secondaire (60) compare la variation temporelle de la température à un seuil prédéterminé, et émet un signal de détection d'un court-circuit lorsque la variation temporelle de la température est supérieure audit seuil prédéterminé.

5. Système selon la revendication 4, dans lequel ledit seuil prédéterminé est supérieur à +1,0°C/s, notamment égal à +1,7°C/s.

6. Système (10) selon l'une quelconque des revendications 1 à 5, dans lequel les moyens de détection secondaires sont également propres à discriminer si le défaut détecté par les moyens de détection primaires est un court-circuit non franc externe à la machine électrique synchrone (14) du type amorçage entre les câbles électrique (23, 24, 25), en comparant la variation temporelle de la température à un second seuil prédéterminé, valant environ +0,5°C/min.

7. Système (110 ; 210) selon l'une quelconque des revendications 1 à 6, dans lequel les moyens de détection secondaires comportent au moins deux capteurs de tensions (161, 162, 163) permettant de mesurer un déséquilibre en tension entre les phases de la machine électrique synchrone (14), les capteurs de tension étant placés au plus près des bornes d'alimentation (P1, P2, P3) de la machine électrique synchrone (14).

8. Système (110 ; 210) selon la revendication 7, dans lequel les moyens de détection secondaires comportent un dispositif de détection (160 ; 260) propre à calculer un écart en tension à partir des mesures délivrées par les capteurs de tension (161, 162, 163) et à générer un signal de détection d'un court-circuit non franc interne à la machine électrique synchrone lorsque l'écart calculé est supérieur à un seuil prédéterminé.

9. Système (110 ; 210) selon la revendication 7 ou la revendication 8, dans lequel un capteur de tension est connecté entre les bornes d'alimentation de deux phases différentes ; ou est connecté entre une borne d'alimentation d'une phase et un point commun de connexion des différents capteurs de tension entre eux, ce point commun pouvant être connecté à une masse électrique du système.

10. Procédé de mise en sécurité mis en oeuvre dans un système de traction (10 ; 110 ; 210) selon l'une quelconque des revendications précédentes, **caractérisé en ce qu'**il comporte les étapes consistant successivement à :
- détecter une surintensité dans au moins une branche de sortie du convertisseur (22) ;
- actionner en ouverture le dispositif d'isolement (26) ;
- puis détecter un défaut du type court-circuit en aval du dispositif d'isolement ; et, dans l'affirmative
- actionner en fermeture les moyens (27) de mise en court-circuit des phases de la machine électrique synchrone (14).

## Patentansprüche

1. Elektrisches Traktionssystem (10; 10, 210) für ein Schienenfahrzeug, eine elektrische Synchronmaschine (14) und einen Versorgungskreis (16) aufweisend, wobei der Versorgungskreis einen Wandler (22), der an eine Gleichspannungsquelle angeschlossen ist und geeignet ist, eine mehrphasige Spannung zu liefern, die an die Versorgung der Maschine angepasst ist, mit der der Wandler über eine Mehrzahl von elektrischen Leitungen (23, 24, 25) verbunden ist, eine Isoliervorrichtung (26) und Mittel (27) zum Kurzschließen der Phasen der Maschine, die hinter der Isoliervorrichtung (26) liegen, aufweist,
wobei das System außerdem Mittel (28) zum Steuern des Wandlers, Primärmittel (32, 30) zur Detektion einer Überspannung in den Ausgangszweigen des Wandlers und Mittel (64) zur Sicherheitsabschaltung aufweist, die geeignet sind, die Isoliervorrichtung (26) bei dem Empfang eines Primärdetektionssignals, das von den Primärmitteln zur Detektion gesendet wird, in die Offenstellung zu bringen,
**dadurch gekennzeichnet, dass** es außerdem Sekundärmittel (62, 60; 161, 162, 163, 160; 161, 162, 163, 260) zur Detektion aufweist, die geeignet sind, das Vorhandensein eines Fehlers der Art eines Kurzschlusses hinter der Isoliervorrichtung zu detektieren und ein Sekundärdetektionssignal an die Mittel (64) zur Sicherheitsabschaltung zu liefern, und dass die Mittel (64) zur Sicherheitsabschaltung geeignet sind, die Mittel (27) zum Kurzschließen der Phasen der Maschine in die Schließstellung bei dem Empfang des Sekundärdetektionssignals zu betätigen, unter der Bedingung, dass sie schon ein von den Primärmitteln zur Detektion geliefertes Primärdetektionssignal empfangen haben und das zur Betätigung in die Offenstellung der Isoliervorrichtung geführt hat.

2. System (10) nach Anspruch 1, bei dem die Sekundärmittel zur Detektion mindestens einen Temperatursensor (62) aufweisen, der geeignet ist, eine Temperatur zu messen, die einer Innentemperatur der elektrischen Synchronmaschine (14) entspricht.

3. System (10) nach Anspruch 2, bei dem die Sekundärmittel zur Detektion eine Sekundärvorrichtung (60) zur Detektion aufweisen, die geeignet ist, eine zeitliche Veränderung der durch den oder jeden Temperatursensor gemessenen Temperatur zu berechnen.

4. System (10) nach Anspruch 3, bei dem die Sekundärvorrichtung (60) zur Detektion die zeitliche Veränderung der Temperatur mit einer vorbestimmten Schwelle vergleicht und ein Signal der Detektion eines Kurzschlusses sendet, wenn die zeitliche Veränderung der Temperatur größer als die vorbestimmte Schwelle ist.

5. System nach Anspruch 4, bei dem die vorbestimmte Schwelle größer als +1,0°C/s, insbesondere gleich +1,7°C/s ist.

6. System (10) nach einem beliebigen der Ansprüche 1 bis 5, bei dem die Sekundärmittel zur Detektion ebenfalls geeignet sind, zu unterscheiden, ob der von den Primärmitteln zur Detektion detektierte Fehler ein Kurzschluss ohne Körperschluss außerhalb der elektrischen Synchronmaschine (14) der Art eines Überschlags zwischen den elektrischen Leitungen (23, 24, 25) ist, indem die zeitliche Veränderung der Temperatur mit einer zweiten vorbestimmten Schwelle verglichen wird, die ungefähr +0,5°C/min beträgt.

7. System (110; 210) nach einem beliebigen der Ansprüche 1 bis 6, bei dem die Sekundärmittel zur Detektion mindestens zwei Spannungssensoren (161, 162, 163) aufweisen, die ein Spannungsungleichgewicht zwischen den Phasen der elektrischen Synchronmaschine (14) messen können, wobei die Spannungssensoren so nah wie möglich an den Versorgungsklemmen (P1, P2, P3) der elektrischen Synchronmaschine (14) angeordnet sind.

8. System (110; 210) nach Anspruch 7, bei dem die Sekundärmittel zur Detektion eine Detektionsvorrichtung (160; 260) aufweisen, die geeignet ist, einen Spannungsunterschied aus den von den Spannungssensoren (161, 162, 163) gelieferten Messungen zu berechnen und ein Detektionssignal eines Kurzschlusses ohne Körperschluss innerhalb der elektrischen Synchronmaschine zu erzeugen, wenn der berechnete Unterschied größer als eine vorgegebene Schwelle ist.

9. System (110; 210) nach Anspruch 7 oder Anspruch 8, bei dem ein Spannungssensor zwischen die Versorgungsklemmen von zwei unterschiedlichen Phasen geschaltet ist; oder zwischen eine Versorgungsklemme einer Phase und einen gemeinsamen Verbindungspunkt der unterschiedlichen Spannungssensoren untereinander geschaltet ist, wobei dieser gemeinsame Punkt an eine elektrische Masse des Systems angeschlossen sein kann.

10. Verfahren zur Sicherheitsabschaltung, das in einem Traktionssystem (10; 110; 210) nach einem beliebigen der vorhergehenden Ansprüche durchgeführt wird, **dadurch gekennzeichnet, dass** es die Schritte aufweist, die aufeinanderfolgend darin bestehen:
- eine Überspannung in mindestens einem Ausgangszweig des Wandlers (22) zu detektieren;
- eine Öffnung der Isoliervorrichtung (26) durchzuführen;
- dann einen Fehler nach Art eines Kurzschlusses hinter der Isoliervorrichtung zu detektieren und im positiven Fall
- die Mittel (27) zum Kurzschließen der Phasen der elektrischen Synchronmaschine (14) zum Schließen zu betätigen.

## Claims

1. An electric traction system (10; 110; 210) for a railway vehicle, comprising a synchronous electric machine (14) and a power supply circuit (16), the power supply circuit including a converter (22), connected to a DC voltage source and delivering a polyphase voltage adapted to power the synchronous electric machine to which the converter is connected by a plurality of electric cables (23, 24, 25), an insulating device (26) and means (27) for short-circuiting the phases of the machines, placed downstream from the insulating device (26),
the electric traction machines further comprising means (28) for controlling the converter, primary detection means (32, 30) for detecting an over-current in a plurality of output branches of the converter, and safety means (64) for actuating the opening of the insulating device upon reception of a primary detection signal emitted by the primary detection means,
**characterized in that** it comprises further secondary detection means (62, 60 ; 161, 162, 160 ; 161, 162, 163, 260) for detecting a fault of the short-circuit type downstream from the insulating device and emitting a secondary detection signal toward the safety means (64),
and **in that** the safety means (64) actuate the closing of the means (27) for short-circuiting the phases of the machine upon reception of the secondary detection signal, on the condition the safety means have already received a primary detection signal emitted by the primary detection means and having led to actuating the opening of the insulating device.

2. The system (10) according to claim 1, wherein the secondary detection means include at least one temperature sensor (62), for measuring a temperature corresponding to an internal temperature of the synchronous electric machine (14).

3. The system (10) according to claim 2, wherein the secondary detection means include a secondary detection device (60) for calculating a time variation of the temperature measured by the or each temperature sensor (62).

4. The system (10) according to claim 3, wherein the secondary detection device (60) compares the time variation of the temperature to a predetermined threshold, and emits a short-circuit detection signal when the time variation of the temperature is above said predetermined threshold.

5. The system according to claim 4, wherein the predetermined threshold is greater than +1.0°C/s in particular equal to +1.7°C/s.

6. The system (10) according to any one of claims 1 to 5, wherein the secondary detection means discriminate whether the fault detected by the primary detection means is a non-dead short-circuit external to the synchronous electric machine (14) of the initiating type between the electric cables (23, 24, 25), by comparing the time variation of the temperature to a second predetermined threshold, of about +0.5°C/min.

7. The system (110; 120) according to any one of claims 1 to 6, wherein the secondary detection means include at least two voltage sensors (161, 162, 163) for measuring a voltage imbalance between the phases of the synchronous electric machine (14), the voltage sensors being placed as close as possible to the power supply terminals (P1, P2, P3) of the synchronous electric machine (14).

8. The system (110; 120) according to claim 7, wherein the secondary detection means include a detection device (160 ; 260) for calculating a voltage deviation from measurements delivered by the voltage sensors (161, 162, 163) and generate a detection signal for a non-dead short-circuit internal to the synchronous electric machine when the calculated deviation is above a predetermined threshold.

9. The system (110; 120) according to claim 7 or claim 8, wherein a voltage sensor is connected between the power supply terminals of two different phases; or is connected between a power supply terminal of a phase and a shared connection point of the different voltage sensors to one another, this shared point being connected to an electric ground of the system.

10. A securing method implemented in a traction system (10, 110; 120) according to any one of claims 1 to 9, **characterized in that** it includes the steps successively consisting of:
- detecting an overvoltage in at least one output branch of the converter (22);
- actuating the opening of the insulating device (26);
- then detecting a fault of the short-circuit type downstream from the insulating device; and, in the affirmative,
- actuating the closing of the short-circuiting means (27) of the phases of the synchronous electric machine (14).
